# EUROPEAN PATENT APPLICATION

(11) **EP 4 712 301 A1**
(43) Date of publication of application: **18.03.2026**
(21) Application number: 25187339.4
(22) Date of filing: 03.07.2025
(51) Int. Cl.: H02J 7/00, G01R 31/40, B60L 53/30, B60L 53/60

(54) **ON-BOARD CHARGING TEST SYSTEM AND METHOD THEREFOR**

(30) Priority: 13.09.2024 TW 113134990
(71) Applicant: Chroma ATE Inc., Taoyuan City 333001 (TW)
(72) Inventor: Chien, Shou-Ting, 333001 Taoyuan City (TW); You, Ciou-Rong, 333001 Taoyuan City (TW); Li, Li-Hsiang, 333001 Taoyuan City (TW)
(74) Representative: Schwarz & Partner Patentanwälte GmbH

(57) **Abstract**

An On-board charge test method includes: providing, according to one of a plurality of test parameter sets, a corresponding charging environment by a power supply system (20) to detect the state of an on-board charger (30) in a corresponding first stage of a plurality of stages (E1-E9) of a charging process, wherein the stages (E1-E9) correspond to the test parameter sets and a plurality of stage enter condition; detecting a control pilot feedback signal generated by the on-board charger (30) in each of the stages (E1-E9); and after the on-board charger (30) enters the first stage for a period of time, providing, according to the one or another one of the test parameter sets, the corresponding charging environment to detect the state of the on-board charger (30) in a corresponding second stage behind the first stage of the stages when the signal parameter of the control pilot feedback signal meets the stage enter condition corresponding to the first stage.

## Description

### BACKGROUND

### Technical Field

The present invention relates to the field of charging tests, and in particular, to an on-board charging test system and a method therefor.

### Related Art

Generally, a charging test manner for an on-board charger (OBC) is an itemized single test. Specifically, when detecting a test item of the OBC (for example, detecting response of the OBC to the power supply from a power supply system while a connection handshake is in progress between the power supply system and the OBC), a user needs to first set a parameter of the power supply system to a first setting parameter in an itemized manner, to provide a corresponding charging environment for the OBC, thereby detecting whether the test item is normal or abnormal. When detecting another test item of the OBC (for example, detecting response of the OBC to a lack of power supply from the power supply system while a connection handshake is in progress between the power supply system and the OBC), the user needs to first set the parameter of the power supply system in an itemized manner to a second setting parameter, to provide a corresponding charging environment for the OBC, thereby detecting whether the another test item is normal or abnormal.

However, a plurality of test items for the OBC generally exist. Therefore, if the charging test of the OBC is performed through the itemized single test, the user needs to reset the parameter of the power supply system in an itemized manner for each specific test item to be performed when detecting different test items. In this way, test efficiency is reduced.

### SUMMARY

In view of the above, the present invention provides an on-board charging test system and a method therefor. The on-board charging test system includes a memory and a processor. The memory has at least one command, a plurality of test parameter sets, and a plurality of stage enter conditions stored therein. The test parameter sets and the stage enter conditions respectively correspond to a plurality of stages of an on-board charger (OBC) in a charging process. The processor is coupled to the memory and configured to access and execute the at least one command in the memory to perform a charging test procedure. The charging test procedure includes: enabling a power supply system to provide a corresponding charging environment based on one of the test parameter sets, to detect a state of an OBC in a corresponding first stage of a plurality of stages of a charging process; detecting a control pilot (CP) feedback signal generated by the OBC in each of the stages; and enabling the power supply system to provide a corresponding charging environment based on the set or another set of the test parameter sets when a signal parameter of the CP feedback signal meets the stage enter condition corresponding to the first stage after the OBC enters the first stage for a period of time, to detect a state of the OBC in a corresponding second stage of the stages. The second stage follows the first stage.

The on-board charging test method includes: enabling a power supply system to provide a corresponding charging environment based on one of a plurality of test parameter sets, to detect a state of an OBC in a corresponding first stage of a plurality of stages of a charging process, where the stages correspond to the test parameter sets and a plurality of stage enter conditions; detecting a CP feedback signal generated by the OBC in each of the stages; and enabling the power supply system to provide a corresponding charging environment based on the set or another set of the test parameter sets when a signal parameter of the CP feedback signal meets the stage enter condition corresponding to the first stage after the OBC enters the first stage for a period of time, to detect a state of the OBC in a corresponding second stage of the stages, where the second stage follows the first stage.

Based on the above, according to some embodiments, the present invention modularizes the charging test of the OBC through the test parameter sets and the stage enter conditions. In this way, the quantity of test items can be reduced under the charging protocol that conforms to the OBC, thereby improving the detecting efficiency.

### BRIEF DESCRIPTION OF THE DRAWINGS

FIG. 1 is a schematic diagram of an on-board charging test system and an application therefor according to some embodiments of the present invention.
FIG. 2 is a schematic diagram of a detailed circuit of a power supply system and an on-board charger (OBC) according to some embodiments of the present invention.
FIG. 3 is a flowchart of an on-board charging test method according to some embodiments of the present invention.
FIG. 4 is a schematic diagram showing states of a power supply system and an OBC at different stages when a test and an OBC operate normally according to some embodiments of the present invention.
FIG. 5 is a flowchart of an on-board charging test method according to some embodiments of the present invention.
FIG. 6 is a flowchart of an on-board charging test method according to some embodiments of the present invention.
FIG. 7 is a flowchart of an on-board charging test method according to some embodiments of the present invention.

### DETAILED DESCRIPTION

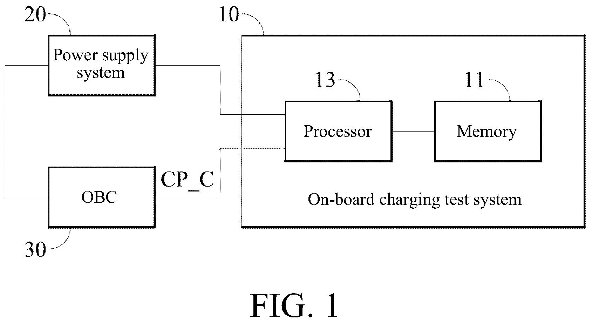

FIG. 1 is a schematic diagram of an on-board charging test system 10 and an application therefor according to some embodiments of the present invention. The on-board charging test system 10 includes a memory 11 and a processor 13. The processor 13 is coupled to the memory 11, a power supply system 20, and an on-board charger (OBC) 30. The processor 13 controls and adjusts a charging environment provided by the power supply system 20. Specifically, the processor 13 controls and adjusts a parameter of the power supply system 20, to provide a corresponding charging environment. The power supply system 20 provides the charging environment to the OBC 30, so that the processor 13 can test response or feedback of the OBC 30 in the charging environment. The memory 11 has at least one command, a plurality of test parameter sets, and a plurality of stage enter conditions stored therein. The processor 13 accesses and executes the at least one command in the memory 11, to perform a charging test procedure of the present invention.

In some embodiments, the memory 11 is, for example, but not limited to, a hard disk drive, a solid-state drive, a flash memory, an optical disk, and the like. The processor 13 is, for example but not limited to an operational circuit such as a central processing unit, a microprocessor, an application-specific integrated circuit (ASIC), or a system on a chip (SOC).

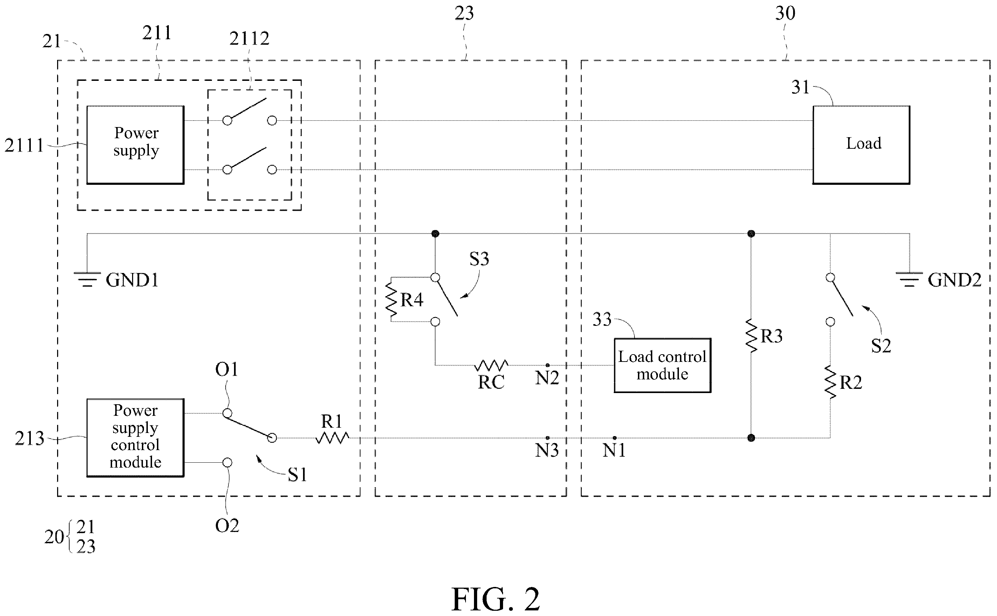

FIG. 2 is a schematic diagram of a detailed circuit of a power supply system 20 and an OBC 30 according to some embodiments of the present invention. In some embodiments, the power supply system 20 includes a power supply device 21 and a vehicle plug 23. The power supply device 21 includes a power supply module 211, a power supply control module 213, a switch (referred to as a first switch S1 below), a first resistor R1, and a first ground terminal GND1. The power supply module 211 includes a power supply 2111 and a contactor 2112. The contactor 2112 is coupled to the power supply 2111. The power supply 2111 is, for example, an alternating current. The contactor 2112 is, for example, an electromagnetic contactor. The first switch S1 is coupled to the power supply control module 213 and the first resistor R1. Specifically, the power supply control module 213 has two output terminals (referred to as a first output terminal O1 and a second output terminal O2 below). The first output terminal O1 outputs a direct current signal. The second output terminal O2 outputs a pulse width modulation (PWM) signal. The first switch S1 is coupled between the first output terminal O1 and the first resistor R1, and is coupled between the second output terminal O2 and the first resistor R1, to switch the first resistor R1 to be turned on with the first output terminal O1 or with the second output terminal O2. The vehicle plug 23 includes a fourth resistor R4, a fifth resistor RC, a switch (referred to as a third switch S3 below), a second node N2, and a third node N3. The fourth resistor R4 is coupled to the first ground terminal GND1 and the fifth resistor RC. The third switch S3 is connected in parallel with the fourth resistor R4. The OBC 30 includes a load 31, a load control module 33, a second resistor R2, a third resistor R3, a switch (referred to as a second switch S2 below), a second ground terminal GND2, and a first node N1. The second node N2 is located between the fifth resistor RC and the load control module 33. The second ground terminal GND2 is coupled to the first ground terminal GND1. The contactor 2112 is coupled to the load 31. The load control module 33 is coupled to the fifth resistor RC. The second switch S2 is coupled to the second ground terminal GND2. The second resistor R2 is coupled to the first resistor R1. The second switch S2 is connected in series with the second resistor R2, and a circuit formed after the second switch S2 is connected in series with the second resistor R2 is connected in parallel with the third resistor R3. The first node N1 and the third node N3 are both located between the first resistor R1 and the second resistor R2. The first switch S1, the second switch S2, and the third switch S3 are, for example, electronic switches. The power supply control module 213 and the load control module 33 may be implemented by an operational circuit such as a microprocessor.

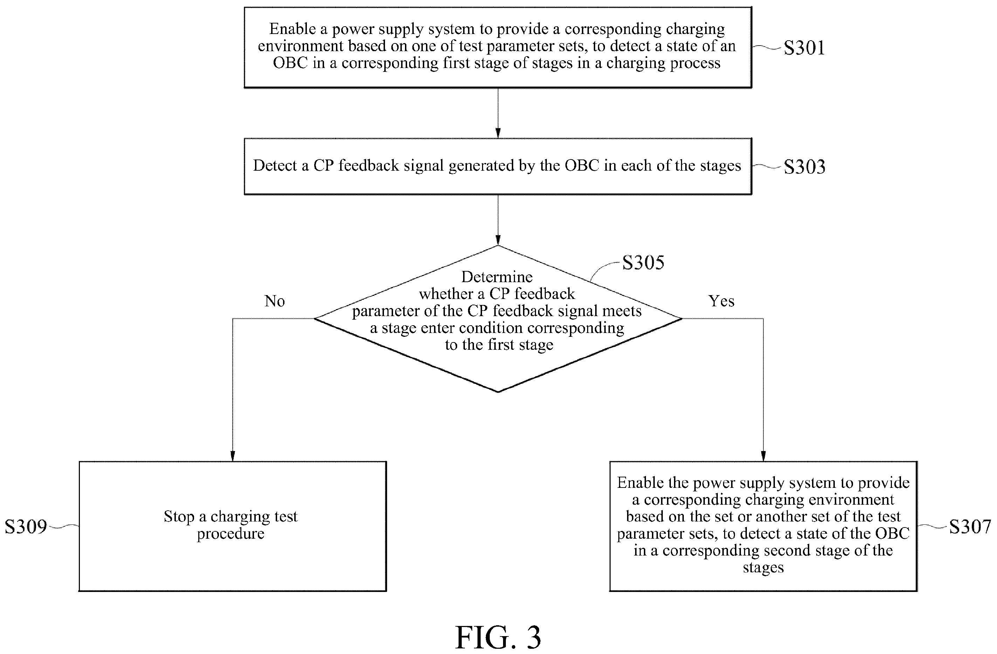

FIG. 3 is a flowchart of an on-board charging test method according to some embodiments of the present invention. In some embodiments, the on-board charging test method is implemented by the foregoing charging test procedure. First, a processor 13 enables a power supply system 20 to provide a corresponding charging environment based on one of the test parameter sets, to detect a state of an OBC 30 in a corresponding first stage of the stages in a charging process (step S301). The stages correspond to the test parameter sets and the stage enter conditions (to be described later). Next, the processor 13 detects a control pilot (CP) feedback signal CP_C (as shown in FIG. 1) generated by the OBC 30 in each of the stages (step S303), to learn response or feedback of the OBC 30 in each of the stages. The CP feedback signal CP_C is a signal extracted from the first node N1 (as shown in FIG. 2). Then, after the OBC 30 enters the first stage for a period of time, the processor 13 determines whether a signal parameter (referred to as a CP feedback parameter below) of the detected CP feedback signal CP_C in the first stage meets a stage enter condition corresponding to the first stage (step S305). When the CP feedback parameter of the detected CP feedback signal CP_C in the first stage meets the stage enter condition corresponding to the first stage, it indicates that a test result is normal. Therefore, the processor 13 enables the power supply system 20 to provide a corresponding charging environment based on the set or another set of the test parameter sets, to detect a state of the OBC 30 in a corresponding second stage of the stages (step S307). When the CP feedback parameter of the detected CP feedback signal CP_C in the first stage does not meet the stage enter condition corresponding to the first stage, it indicates that the test result is abnormal. Therefore, the processor 13 stops the charging test procedure (step S309). The second stage follows the first stage. Each of the test parameter sets and each of the stage enter conditions can be defined by a user. In this way, test items required by the OBC 30 in a single stage can be modularized into corresponding test parameter sets and stage enter conditions, to reduce an adjustment of parameters of the user while complying with a charging protocol of the OBC 30 (for example, a GB/T 18487.1 charging protocol), thereby improving test efficiency.

As shown in FIG. 2, in some embodiments, each of the test parameter sets includes a power supply parameter of the power supply 2111, a resistance parameter of the second node N2 (for example, a set value of the fourth resistor R4 and a set value of the fifth resistor RC), a signal parameter of a CP transmission signal of the third node N3 (referred to as a CP transmission parameter below), and the like. In some embodiments, the power supply parameter includes a set power supply voltage, a power supply voltage upper limit, a set power supply voltage frequency, a set power supply voltage phase, a set power supply current, a power supply current upper limit, a set power supply current frequency, a set power supply current phase, and the like. In some embodiments, the CP transmission parameter includes a set CP transmission peak voltage, a set CP transmission valley voltage, a set CP transmission voltage duty cycle, a set CP transmission voltage frequency, and the like.

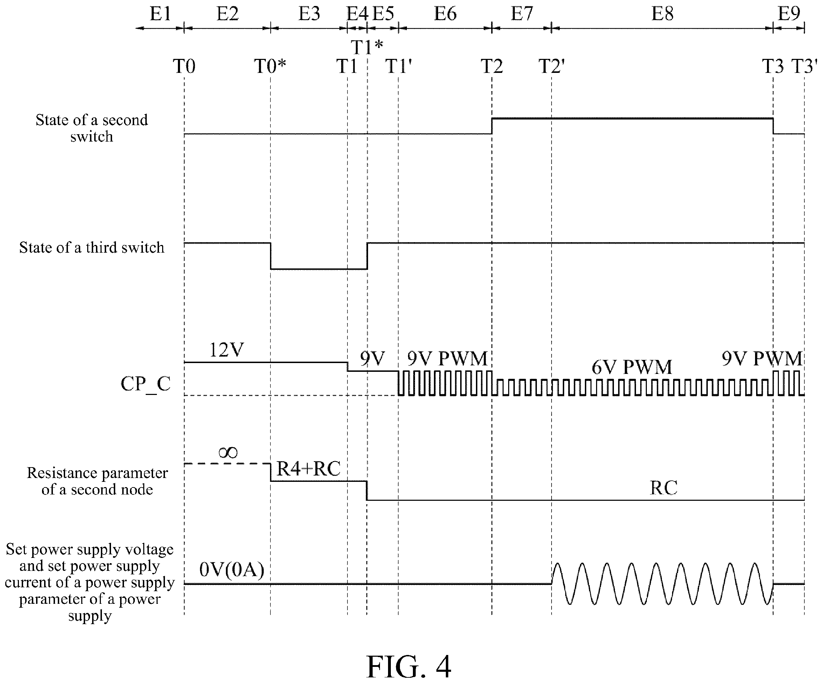

FIG. 4 is a schematic diagram showing states of a power supply system 20 and an OBC 30 at different stages when a test and an OBC 30 operate normally according to some embodiments of the present invention. In FIG. 4, a high level of a second switch S2 and a third switch S3 represents that the second switch S2 and the third switch S3 are in an on state, and a low level of the second switch S2 and the third switch S3 represents that the second switch S2 and the third switch S3 are in an off state. In some embodiments, the test parameter sets include a startup test parameter set, a handshake test parameter set, a connection test parameter set, a charging test parameter set, and a charging completion test parameter set. In some embodiments, the stage enter conditions include a first determining condition, a second determining condition, a third determining condition, a fourth determining condition, and a fifth determining condition. In some embodiments, the stages include a ready-to-startup stage E1, a startup stage E2, a ready-to-handshake stage E3, a pre-handshake stage E4, an in-handshake stage E5, a post-handshake stage E6, a charging preparation stage E7, a charging stage E8, and a charging completion stage E9. As shown in FIG. 4, the ready-to-startup stage E1 is a stage before a timing point T0. The startup stage E2 is a stage from the timing point T0 to a timing point T0*. The ready-to-handshake stage E3 is a stage from the timing point T0* to a timing point T1. The pre-handshake stage E4 is a stage from the timing point T1 to a timing point T1*. The in-handshake stage E5 is a stage from the timing point T1* to a timing point T1'. The post-handshake stage E6 is a stage from the timing point T1' to a timing point T2. The charging preparation stage E7 is a stage from the timing point T2 to a timing point T2'. The charging stage E8 is a stage from the timing point T2' to a timing point T3. The charging completion stage E9 is a stage from the timing point T3 to a timing point T3'. In other words, the startup stage E2 follows the ready-to-startup stage E1, the ready-to-handshake stage E3 follows the startup stage E2, and so forth.

In some embodiments, the CP feedback parameter of the CP feedback signal CP_C includes a peak voltage (referred to as a CP feedback peak voltage below), a valley voltage (referred to as a CP feedback valley voltage below), and a voltage duty cycle (referred to as a CP feedback voltage duty cycle below). Each of the stage enter conditions (to be specific, each of the first determining condition, the second determining condition, the third determining condition, the fourth determining condition, and the fifth determining condition) includes that the CP feedback peak voltage is within a set enter peak voltage range, the CP feedback valley voltage is within a set enter valley voltage range, and the CP feedback voltage duty cycle is within a set enter duty cycle range.

In some embodiments, the startup stage E2 corresponds to the startup test parameter set of the test parameter sets and the first determining condition of the stage enter conditions. The ready-to-handshake stage E3 corresponds to the handshake test parameter set of the test parameter sets and the second determining condition of the stage enter conditions. Step S301 and step S305 are described by using the startup stage E2 as the first stage and the ready-to-handshake stage E3 as the second stage. Specifically, as shown in FIG. 4, the processor 13 enables the power supply system 20 to provide a corresponding charging environment based on the startup test parameter set, to detect a state of the OBC 30 in the startup stage E2. Then, after the OBC 30 enters the startup stage E2 for a period of time (such as reaching the timing point T0*), the processor 13 determines whether the CP feedback parameter of the detected CP feedback signal CP_C in the startup stage E2 meets the first determining condition. When the CP feedback parameter of the detected CP feedback signal CP_C in the startup stage E2 meets the first determining condition, the processor 13 enables the power supply system 20 to provide a corresponding charging environment based on the handshake test parameter set, to detect a state of the OBC 30 in the ready-to-handshake stage E3. When the CP feedback parameter of the detected CP feedback signal CP_C in the startup stage E2 does not meet the first determining condition, the processor 13 stops the charging test procedure.

That the CP feedback parameter of the detected CP feedback signal CP_C in the startup stage E2 meets the first determining condition means that the CP feedback peak voltage of the detected CP feedback parameter in the startup stage E2 is within a set enter peak voltage range of the first determining condition, the CP feedback valley voltage of the detected CP feedback parameter in the startup stage E2 is within a set enter valley voltage range of the first determining condition, and the CP feedback voltage duty cycle of the detected CP feedback parameter in the startup stage E2 is within a set enter duty cycle range of the first determining condition. That the CP feedback parameter of the detected CP feedback signal CP_C in the startup stage E2 meets the first determining condition means that the CP feedback peak voltage of the detected CP feedback parameter in the startup stage E2 is outside a set enter peak voltage range of the first determining condition, the CP feedback valley voltage of the detected CP feedback parameter in the startup stage E2 is outside a set enter valley voltage range of the first determining condition, and/or the CP feedback voltage duty cycle of the detected CP feedback parameter in the startup stage E2 is outside a set enter duty cycle range of the first determining condition.

As shown in FIG. 4, in an exemplary example, when the test and the OBC 30 operate normally, the set CP transmission peak voltage of the CP transmission parameter of the CP transmission signal of the third node N3 of the startup test parameter set is +12 volts (V), the set CP transmission valley voltage is 0 V, and the set CP transmission voltage duty cycle is 100%. In other words, the CP transmission signal of the third node N3 of the startup test parameter set is a 12 V direct current signal. A resistance parameter of the second node N2 of the startup test parameter set is infinite. A set power supply voltage of the power supply parameter of the startup test parameter set is 0 V, and the set power supply current is 0 ampere (A). The set enter peak voltage range of the first determining condition is a range calculated by adding +12 V plus an error interval. The set enter valley voltage range is a range calculated after 0 V plus an error interval, and the set enter duty cycle range is a range calculated after 100% plus an error interval. The error interval may be defined by a user, for example, ± 1%.

Since the OBC 30 has not successfully connected to the power supply system 20 during the startup stage E2, if both the OBC 30 and the power supply system 20 operate normally, the CP feedback parameter of the detected CP feedback signal CP_C in the startup stage E2 is equivalent to the CP transmission parameter of the CP transmission signal of the third node N3 of the startup test parameter set. For example, the CP feedback peak voltage, the CP feedback valley voltage, and the CP feedback voltage duty cycle of the CP feedback parameter of the detected CP feedback signal CP_C in the startup stage E2 are respectively equal to the set CP transmission peak voltage, the set CP transmission valley voltage, and the set CP transmission voltage duty cycle of the CP transmission parameter of the startup test parameter set. In other words, the detected CP feedback signal CP_C in the startup stage E2 is a 12 V direct current signal.

In some embodiments of step S301, in a case that the startup stage E2 is used as the first stage, the third switch S3 remains disconnected between the fifth resistor RC and the first ground terminal GND1 (namely, the third switch S3 is in an off state) when the OBC 30 is in the ready-to-startup stage E1 before the startup stage E2. After the vehicle plug 23 is inserted into the OBC 30, a user inputs an instruction to the processor 13 to control the third switch S3 to turn on the connection between the fifth resistor RC and the first ground terminal GND1 (namely, the third switch S3 is in an on state), and generate a turn-on signal. The processor 13, in response to the turn-on signal of the third switch S3 of the vehicle plug 23, enters the test of the startup stage E2, and enables the power supply system 20 to provide a corresponding charging environment based on the startup test parameter set, to detect the state of the OBC 30 in the startup stage E2.

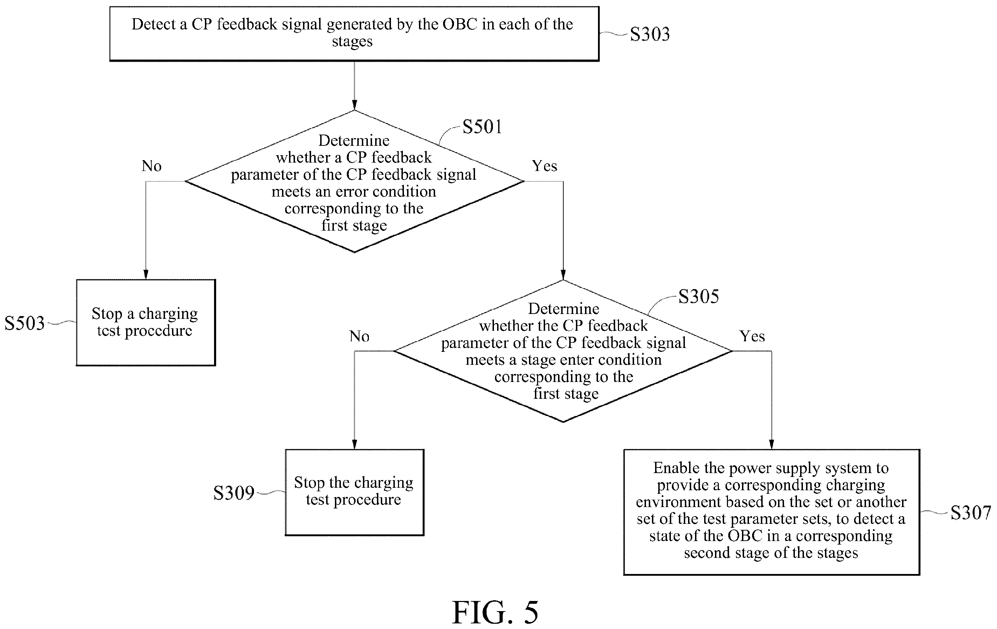

FIG. 5 is a flowchart of an on-board charging test method according to some embodiments of the present invention. In some embodiments, a memory 11 has a plurality of error conditions stored therein. The error conditions correspond to stages of a charging process of an OBC 30 (to be described later). In some embodiments, within a period of time after the OBC 30 enters a first stage, the processor 13 determines whether a CP feedback parameter of a detected CP feedback signal CP_C in the first stage meets an error condition corresponding to the first stage (step S501). When a CP feedback parameter of the detected CP feedback signal CP_C in the first stage does not meet the error condition corresponding to the first stage, it indicates that an anomaly exists in the test process. Therefore, the processor 13 stops a charging test procedure (step S503). When the CP feedback parameter of the detected CP feedback signal CP_C in the first stage meets the error condition corresponding to the first stage, it indicates that the test process is normal. Therefore, the processor 13 performs step S305 and subsequent steps. In some embodiments, each of the plurality of error conditions can be defined by a user.

In some embodiments, the error conditions include a sixth determining condition, a seventh determining condition, an eighth determining condition, a ninth determining condition, and a tenth determining condition. In some embodiments, the sixth determining condition, the seventh determining condition, the eighth determining condition, the ninth determining condition, and the tenth determining condition are respectively the same as the first determining condition, the second determining condition, the third determining condition, the fourth determining condition, and the fifth determining condition of the plurality of stage enter conditions. In some embodiments, each of the error conditions (namely, each of the sixth determining condition, the seventh determining condition, the eighth determining condition, the ninth determining condition, and the tenth determining condition) includes that the CP feedback peak voltage of the CP feedback parameter of the CP feedback signal CP_C is within a set error peak voltage range, the CP feedback valley voltage of the CP feedback parameter is within a set error valley voltage range, and the CP feedback voltage duty cycle of the CP feedback parameter is within a set error duty cycle range.

In some embodiments, the startup stage E2 corresponds to the sixth determining condition of the error conditions. Step S501 and step S503 are described by using the startup stage E2 as the first stage. Specifically, as shown in FIG. 4, within a period of time after the OBC 30 enters the startup stage E2 (for example, after the timing point T0 but before the timing point T0*, namely, before reaching the timing point T0*), the processor 13 determines whether the CP feedback parameter of the detected CP feedback signal CP_C in the startup stage E2 meets the sixth determining condition. When the CP feedback parameter of the detected CP feedback signal CP_C in the startup stage E2 does not meet the sixth determining condition, the processor 13 stops the charging test procedure. When the CP feedback parameter of the detected CP feedback signal CP_C in the startup stage E2 meets the sixth determining condition, the processor 13 performs step S305 and subsequent steps.

In some embodiments, since the sixth determining condition of the error condition is the same as the first determining condition of the stage enter condition (specifically, the set error peak voltage range, the set error valley voltage range, and the set error duty cycle range of the sixth determining condition are respectively the same as the set enter peak voltage range, the set enter valley voltage range, and the set enter duty cycle range of the first determining condition), details are not repeated. Since the determining manner in which the CP feedback parameter of the CP feedback signal CP_C meets the sixth determining condition is similar to the determining manner in which the CP feedback parameter of the CP feedback signal CP_C meets the first determining condition, details are not repeated. Since the determining manner in which the CP feedback parameter of the CP feedback signal CP_C meets the sixth determining condition is similar to the determining manner in which the CP feedback parameter of the CP feedback signal CP_C does not meet the first determining condition, details are not repeated.

In some embodiments, the ready-to-handshake stage E3 corresponds to the handshake test parameter set of the test parameter sets and the second determining condition of the stage enter conditions. The pre-handshake stage E4 corresponds to the handshake test parameter set of the test parameter sets and the second determining condition of the stage enter conditions. Step S301 and step S305 are described by using the ready-to-handshake stage E3 as the first stage and the pre-handshake stage E4 as the second stage. Specifically, as shown in FIG. 4, the processor 13 enables the power supply system 20 to provide a corresponding charging environment based on the handshake test parameter set, to detect a state of the OBC 30 in the ready-to-handshake stage E3. Then, after the OBC 30 enters the ready-to-handshake stage E3 for a period of time (such as reaching the timing point T1), the processor 13 determines whether the CP feedback parameter of the detected CP feedback signal CP_C in the ready-to-handshake stage E3 meets the second determining condition. When the CP feedback parameter of the detected CP feedback signal CP_C in the ready-to-handshake stage E3 meets the second determining condition, the processor 13 enables the power supply system 20 to provide a corresponding charging environment based on the handshake test parameter set, to detect a state of the OBC 30 in the pre-handshake stage E4. When the CP feedback parameter of the detected CP feedback signal CP_C in the ready-to-handshake stage E3 does not meet the second determining condition, the processor 13 stops the charging test procedure.

Since the determining manner in which the CP feedback parameter of the CP feedback signal CP_C meets the second determining condition of the plurality of stage enter conditions is similar to the determining manner in which the CP feedback parameter of the CP feedback signal CP_C meets the first determining condition of the plurality of stage enter conditions, details are not repeated. Since the determining manner in which the CP feedback parameter of the CP feedback signal CP_C does not meet the second determining condition of the stage enter conditions is similar to the determining manner in which the CP feedback parameter of the CP feedback signal CP_C does not meet the first determining condition of the stage enter conditions, details are not repeated.

As shown in FIG. 4, in an exemplary example, when the test and the OBC 30 operate normally, the set CP transmission peak voltage of the CP transmission parameter of the CP transmission signal of the third node N3 of the handshake test parameter set is +12 V, the set CP transmission valley voltage is 0 V, and the set CP transmission voltage duty cycle is 100%. In other words, the CP transmission signal of the third node N3 of the handshake test parameter set is a 12 V direct current signal. In the ready-to-handshake stage E3 and the pre-handshake stage E4, the resistance parameter of the second node N2 of the handshake test parameter set is a sum of a resistance value of the fourth resistor R4 and a resistance value of the fifth resistor RC. The set power supply voltage of the power supply parameter of the handshake test parameter set is 0 V The set power supply current is 0 A. The set enter peak voltage range of the second determining condition is a range calculated by adding +9 V plus an error interval. The set enter valley voltage range is a range calculated after 0 V plus an error interval, and the set enter duty cycle range is a range calculated after 100% plus an error interval. The error interval may be defined by a user, for example, ± 1%.

Since after entering the ready-to-handshake stage E3 for a period of time (for example, reaching the timing point T1), the OBC 30 is initially connected to the power supply system 20, and the second switch S2 does not turn on a connection between the second resistor and the second ground terminal GND2 (namely, the second switch S2 is in an off state), the CP transmission signal of the third node N3 forms the CP feedback signal CP_C through the third resistor R3. Specifically, the set CP transmission peak voltage +12 V of the CP transmission parameter of the CP transmission signal of the third node N3 of the handshake test parameter set is pulled down to +9 V by the third resistor R3, to form the CP feedback peak voltage of the CP feedback parameter of the CP feedback signal CP_C. Moreover, the CP feedback valley voltage and the CP feedback voltage duty cycle of the CP feedback parameter respectively remain equal to the set CP transmission valley voltage and the set CP transmission voltage duty cycle of the CP transmission parameter of the handshake test parameter set. In other words, after the OBC 30 enters the ready-to-handshake stage E3 for a period of time (for example, reaching the timing point T1), the detected CP feedback signal CP_C is a 9 V direct current signal. In this way, by determining whether the CP feedback parameter of the CP feedback signal CP_C satisfies the second determining condition after the OBC 30 enters the ready-to-handshake stage E3 for a period of time (for example, reaching the timing point T1), it can be learned that a test of a next stage (such as the pre-handshake stage E4) can proceed when the second determining condition is met.

In some embodiments, the ready-to-handshake stage E3 corresponds to the sixth determining condition of the error conditions. Therefore, when the ready-to-handshake stage E3 is used as the first stage, the processor 13 performs step S501 through the sixth determining condition of the error conditions.

In some embodiments, the pre-handshake stage E4 corresponds to the handshake test parameter set of the test parameter sets and the second determining condition of the stage enter conditions. The in-handshake stage E5 corresponds to the handshake test parameter set of the test parameter sets and the third determining condition of the stage enter conditions. The manner of using the pre-handshake stage E4 as the first stage of step S301 and the in-handshake stage E5 as the second stage of step S305 is the same as the manner of using the ready-to-handshake stage E3 as the first stage of step S301 and the pre-handshake stage E4 as the second stage of step S305. Therefore, details are not repeated.

In some embodiments, the pre-handshake stage E4 corresponds to the seventh determining condition of the error conditions. Therefore, when the pre-handshake stage E4 is used as the first stage, the processor 13 performs step S501 through the seventh determining condition of the error conditions. In some embodiments, since the seventh determining condition of the error condition is the same as the second determining condition of the stage enter condition (specifically, the set error peak voltage range, the set error valley voltage range, and the set error duty cycle range of the seventh determining condition are respectively the same as the set enter peak voltage range, the set enter valley voltage range, and the set enter duty cycle range of the second determining condition), details are not repeated. Since the determining manner in which the CP feedback parameter of the CP feedback signal CP_C meets the seventh determining condition is similar to the determining manner in which the CP feedback parameter of the CP feedback signal CP_C meets the second determining condition, details are not repeated. Since the determining manner in which the CP feedback parameter of the CP feedback signal CP_C meets the seventh determining condition is similar to the determining manner in which the CP feedback parameter of the CP feedback signal CP_C does not meet the second determining condition, details are not repeated.

In some embodiments, the in-handshake stage E5 corresponds to the handshake test parameter set of the test parameter sets and the third determining condition of the stage enter conditions. The post-handshake stage E6 corresponds to the connection test parameter set of the test parameter sets and the fourth determining condition of the stage enter conditions. Step S301 and step S305 are described by using the in-handshake stage E5 as the first stage and the post-handshake stage E6 as the second stage. Specifically, as shown in FIG. 4, the processor 13 enables the power supply system 20 to provide a corresponding charging environment based on the handshake test parameter set, to detect a state of the OBC 30 in the in-handshake stage E5. Then, after the OBC 30 enters the in-handshake stage E5 for a period of time (such as reaching the timing point T1'), the processor 13 enables the power supply system 20 to provide a corresponding charging environment based on the connection test parameter set, and determines whether the CP feedback parameter of the detected CP feedback signal CP_C in the in-handshake stage E5 meets the third determining condition. When the CP feedback parameter of the detected CP feedback signal CP_C in the in-handshake stage E5 meets the third determining condition, the processor 13 enables the power supply system 20 to provide, still based on the connection test parameter set, a corresponding charging environment to detect the state of the OBC 30 in the post-handshake stage E6. When the CP feedback parameter of the detected CP feedback signal CP_C in the in-handshake stage E5 does not meet the third determining condition, the processor 13 stops the charging test procedure.

Since the determining manner in which the CP feedback parameter of the CP feedback signal CP_C meets the third determining condition of the stage enter conditions is similar to the determining manner in which the CP feedback parameter of the CP feedback signal CP_C does not meet the first determining condition of the stage enter conditions, details are not repeated. Since the determining manner in which the CP feedback parameter of the CP feedback signal CP_C does not meet the third determining condition of the stage enter conditions is similar to the determining manner in which the CP feedback parameter of the CP feedback signal CP_C does not meet the first determining condition of the stage enter conditions, details are not repeated.

As shown in FIG. 4, in an exemplary example, when the test and the OBC 30 operate normally, during the in-handshake stage E5, the resistance parameter of the second node N2 of the handshake test parameter set is the resistance value of the fifth resistor RC. The set CP transmission peak voltage of the CP transmission parameter of the CP transmission signal of the third node N3 of the connection test parameter set is +12 V. The set CP transmission valley voltage is -12 V. The set CP transmission voltage duty cycle is 89.2%. In other words, the CP transmission signal of the third node N3 of the connection test parameter set is a 12 V PWM signal. The resistance parameter of the second node N2 of the connection test parameter set is the resistance value of the fifth resistor RC. The set power supply voltage of the power supply parameter of the connection test parameter set is 0 V and the set power supply current is 0 A. The set enter peak voltage range of the third determining condition is a range calculated by adding +9 V plus an error interval. The set enter valley voltage range is a range calculated after 0 V plus an error interval, and the set enter duty cycle range is a range calculated after 89.2% plus an error interval. The error interval may be defined by a user, for example, ± 1%.

Since after entering the in-handshake stage E5 for a period of time (for example, reaching the timing point T1'), the OBC 30 has established a specific degree of connection handshake with the power supply system 20, the power supply system 20 outputs a PWM signal (to be specific, a 12 V PWM signal) with a peak of +12 V (for example, the set CP transmission peak voltage of the connection test parameter set) and a valley of -12 V (for example, the set CP transmission valley voltage of the connection test parameter set) at the third node N3 as the CP transmission signal. In this case, the second switch S2 does not turn on a connection between the second resistor R2 and the second ground terminal GND2 (namely, the second switch S2 is in an off state). Therefore, the CP transmission signal of the third node N3 still forms the CP feedback signal CP_C through the third resistor R3. Specifically, due to the third resistor R3, the CP feedback peak voltage of the CP feedback parameter of the CP feedback signal CP_C is 9 V, the CP feedback valley voltage of the CP feedback parameter is 0 V, and the CP feedback voltage duty cycle of the CP feedback parameter is 89.2%. In other words, the CP feedback signal CP_C becomes a 9 V PWM signal. In this way, by determining whether the CP feedback parameter of the CP feedback signal CP_C meets the third determining condition after the OBC 30 enters the in-handshake stage E5 for a period of time (for example, reaching the timing point T1'), it can be learned that a test of a next stage (such as the post-handshake stage E6) can proceed when the third determining condition is met.

In some embodiments, the in-handshake stage E5 corresponds to the seventh determining condition of the error conditions. Therefore, when the in-handshake stage E5 is used as the first stage, the processor 13 performs step S501 through the seventh determining condition of the error conditions.

In some embodiments, the post-handshake stage E6 corresponds to the connection test parameter set of the test parameter sets and the fourth determining condition of the stage enter conditions. The charging preparation stage E7 corresponds to the connection test parameter set of the test parameter sets and the fourth determining condition of the stage enter conditions. Step S301 and step S305 are described by using the post-handshake stage E6 as the first stage and the charging preparation stage E7 as the second stage. Specifically, as shown in FIG. 4, the processor 13 enables the power supply system 20 to provide a corresponding charging environment based on the connection test parameter set, to detect the state of the OBC 30 in the post-handshake stage E6. Then, after the OBC 30 enters the post-handshake stage E6 for a period of time (such as reaching the timing point T2), the processor 13 determines whether the CP feedback parameter of the detected CP feedback signal CP_C in the post-handshake stage E6 meets the fourth determining condition. When the CP feedback parameter of the detected CP feedback signal CP_C in the post-handshake stage E6 meets the fourth determining condition, the processor 13 enables the power supply system 20 to provide a corresponding charging environment based on the connection test parameter set, to detect the state of the OBC 30 in the charging preparation stage E7. When the CP feedback parameter of the detected CP feedback signal CP_C in the post-handshake stage E6 does not meet the fourth determining condition, the processor 13 stops the charging test procedure.

Since the determining manner in which the CP feedback parameter of the CP feedback signal CP_C meets the fourth determining condition of the stage enter conditions is similar to the determining manner in which the CP feedback parameter of the CP feedback signal CP_C meets the first determining condition of the stage enter conditions, details are not repeated. Since the determining manner in which the CP feedback parameter of the CP feedback signal CP_C does not meet the fourth determining condition of the stage enter conditions is similar to the determining manner in which the CP feedback parameter of the CP feedback signal CP_C does not meet the first determining condition of the stage enter conditions, details are not repeated.

As shown in FIG. 4, in an exemplary example, when the test and the OBC 30 operate normally, the set enter peak voltage range of the fourth determining condition is a range calculated by adding +6 V plus an error interval. The set enter valley voltage range is a range calculated after 0 V plus an error interval, and the set enter duty cycle range is a range calculated after 89.2% plus an error interval. The error interval may be defined by a user, for example, ± 1%.

After entering the post-handshake stage E6 for a period of time (for example, reaching the timing point T2), the OBC 30 completes the connection handshake with the power supply system 20. The power supply system 20 continuously outputs a PWM signal (to be specific, a 12 V PWM signal) with a peak of +12 V (for example, the set CP transmission peak voltage of the connection test parameter set) and a valley of -12 V (for example, the set CP transmission valley voltage of the connection test parameter set) at the third node N3 as the CP transmission signal. In this case, the second switch S2 turns on the connection between the second resistor and the second ground terminal GND2 (namely, the second switch S2 is in an on state). Therefore, the CP transmission signal of the third node N3 forms the CP feedback signal CP_C through a parallel circuit formed by the third resistor R3 and the second resistor R2. Specifically, due to the parallel circuit formed by the third resistor R3 and the second resistor R2, the CP feedback peak voltage of the CP feedback parameter of the CP feedback signal CP_C is 6 V, the CP feedback valley voltage of the CP feedback parameter is 0 V, and the CP feedback voltage duty cycle of the CP feedback parameter is 89.2%. In other words, the CP feedback signal CP_C becomes a 6 V PWM signal. In this way, by determining whether the CP feedback parameter of the CP feedback signal CP_C meets the fourth determining condition after the OBC 30 enters the post-handshake stage E6 for a period of time (for example, reaching the timing point T2), it can be learned that a test of a next stage (such as the charging preparation stage E7) can proceed when the fourth determining condition is met.

In some embodiments, the post-handshake stage E6 corresponds to the eighth determining condition of the error conditions. Therefore, when the post-handshake stage E6 is used as the first stage, the processor 13 performs step S501 through the eighth determining condition of the error conditions. In some embodiments, since the eighth determining condition of the error conditions is the same as the third determining condition of the stage enter conditions (specifically, the set error peak voltage range, the set error valley voltage range, and the set error duty cycle range of the eighth determining condition are respectively the same as the set enter peak voltage range, the set enter valley voltage range, and the set enter duty cycle range of the third determining condition), details are not repeated. Since the determining manner in which the CP feedback parameter of the CP feedback signal CP_C meets the eighth determining condition is similar to the determining manner in which the CP feedback parameter of the CP feedback signal CP_C meets the third determining condition, details are not repeated. Since the determining manner in which the CP feedback parameter of the CP feedback signal CP_C meets the eighth determining condition is similar to the determining manner in which the CP feedback parameter of the CP feedback signal CP_C does not meet the third determining condition, details are not repeated.

In some embodiments, the charging preparation stage E7 corresponds to the connection test parameter set of the test parameter sets and the fourth determining condition of the stage enter conditions. The charging stage E8 corresponds to the charging test parameter set of the test parameter sets and the fifth determining condition of the stage enter conditions. The manner of using the charging preparation stage E7 as the first stage of step S301 and the charging stage E8 as the second stage of step S305 is the same as the manner of using the post-handshake stage E6 as the first stage of step S301 and the charging preparation stage E7 as the second stage of step S305. Therefore, details are not repeated.

In some embodiments, the charging preparation stage E7 corresponds to the ninth determining condition of the error conditions. Therefore, when the charging preparation stage E7 is used as the first stage, the processor 13 performs step S501 through the ninth determining condition of the error conditions. In some embodiments, since the ninth determining condition of the error conditions is the same as the fourth determining condition of the stage enter conditions (specifically, the set error peak voltage range, the set error valley voltage range, and the set error duty cycle range of the ninth determining condition are respectively the same as the set enter peak voltage range, the set enter valley voltage range, and the set enter duty cycle range of the fourth determining condition), details are not repeated. Since the determining manner in which the CP feedback parameter of the CP feedback signal CP_C meets the ninth determining condition is similar to the determining manner in which the CP feedback parameter of the CP feedback signal CP_C meets the fourth determining condition, details are not repeated. Since the determining manner in which the CP feedback parameter of the CP feedback signal CP_C meets the ninth determining condition is similar to the determining manner in which the CP feedback parameter of the CP feedback signal CP_C does not meet the fourth determining condition, details are not repeated.

In some embodiments, the charging stage E8 corresponds to the charging test parameter set of the test parameter sets and the fifth determining condition of the stage enter conditions. The charging completion stage E9 corresponds to the charging completion test parameter set of the test parameter sets. Step S301 and step S305 are described by using the charging stage E8 as the first stage and the charging completion stage E9 as the second stage. Specifically, as shown in FIG. 4, the processor 13 enables the power supply system 20 to provide a corresponding charging environment based on the charging test parameter set, to detect the state of the OBC 30 in the charging stage E8. Then, after the OBC 30 enters the charging stage E8 for a period of time (such as reaching the timing point T3), the processor 13 determines whether the CP feedback parameter of the detected CP feedback signal CP_C in the charging stage E8 meets the fifth determining condition. When the CP feedback parameter of the detected CP feedback signal CP_C in the charging stage E8 meets the fifth determining condition, the processor 13 enables the power supply system 20 to provide a corresponding charging environment based on the charging completion test parameter set, to detect the state of the OBC 30 in the charging completion stage E9. When the CP feedback parameter of the detected CP feedback signal CP_C in the charging stage E8 does not meet the fifth determining condition, the processor 13 stops the charging test procedure.

Since the determining manner in which the CP feedback parameter of the CP feedback signal CP_C meets the fifth determining condition of the stage enter conditions is similar to the determining manner in which the CP feedback parameter of the CP feedback signal CP_C meets the first determining condition of the stage enter conditions, details are not repeated. Since the determining manner in which the CP feedback parameter of the CP feedback signal CP_C does not meet the fifth determining condition of the stage enter conditions is similar to the determining manner in which the CP feedback parameter of the CP feedback signal CP_C does not meet the first determining condition of the stage enter conditions, details are not repeated.

As shown in FIG. 4, in an exemplary example, when the test and the OBC 30 operate normally, the set CP transmission peak voltage of the CP transmission parameter of the CP transmission signal of the third node N3 of the charging test parameter set is +12 V, the set CP transmission valley voltage is -12 V, and the set CP transmission voltage duty cycle is 89.2%. In other words, the CP transmission signal of the third node N3 of the charging test parameter set is a 12 V PWM signal. The resistance parameter of the second node N2 of the charging test parameter set is the resistance value of the fifth resistor RC. The set power supply voltage of the power supply parameter of the charging test parameter set is greater than 0 V and the set power supply current is greater than 0 A. The set enter peak voltage range of the fifth determining condition is a range calculated by adding +9 V plus an error interval. The set enter valley voltage range is a range calculated after 0 V plus an error interval, and the set enter duty cycle range is a range calculated after 89.2% plus an error interval. The error interval may be defined by a user, for example, ± 1%.

After entering the charging stage E8, the power supply system 20 begins supplying power to the OBC 30. The power supply system 20 continuously outputs a PWM signal (to be specific, a 12 V PWM signal) with a peak of +12 V (for example, the set CP transmission peak voltage of the charging test parameter set) and a valley of -12 V (for example, the set CP transmission valley voltage of the charging test parameter set) at the third node N3 as the CP transmission signal. After entering the charging stage E8 for a period of time (for example, reaching the timing point T3), the second switch S2 does not turn on the connection between the second resistor R2 and the second ground terminal GND2 (namely, the second switch S2 is in an off state) if the OBC 30 is fully charged. Therefore, the CP transmission signal of the third node N3 forms the CP feedback signal CP_C through the third resistor R3. Specifically, due to the third resistor R3, the CP feedback peak voltage of the CP feedback parameter of the CP feedback signal CP_C is 9 V, the CP feedback valley voltage of the CP feedback parameter is 0 V, and the CP feedback voltage duty cycle of the CP feedback parameter is 89.2%. In other words, the CP feedback signal CP_C becomes a 9 V PWM signal. In this way, by determining whether the CP feedback parameter of the CP feedback signal CP_C meets the fifth determining condition after the OBC 30 enters the charging stage E8 for a period of time (for example, reaching the timing point T3), it can be learned that the OBC 30 is fully charged and a test of a next stage (such as the charging completion stage E9) can proceed when the fifth determining condition is met.

In some embodiments, the charging stage E8 corresponds to the ninth determining condition of the error conditions. Therefore, when the charging stage E8 is used as the first stage, the processor 13 performs step S501 through the ninth determining condition of the error conditions.

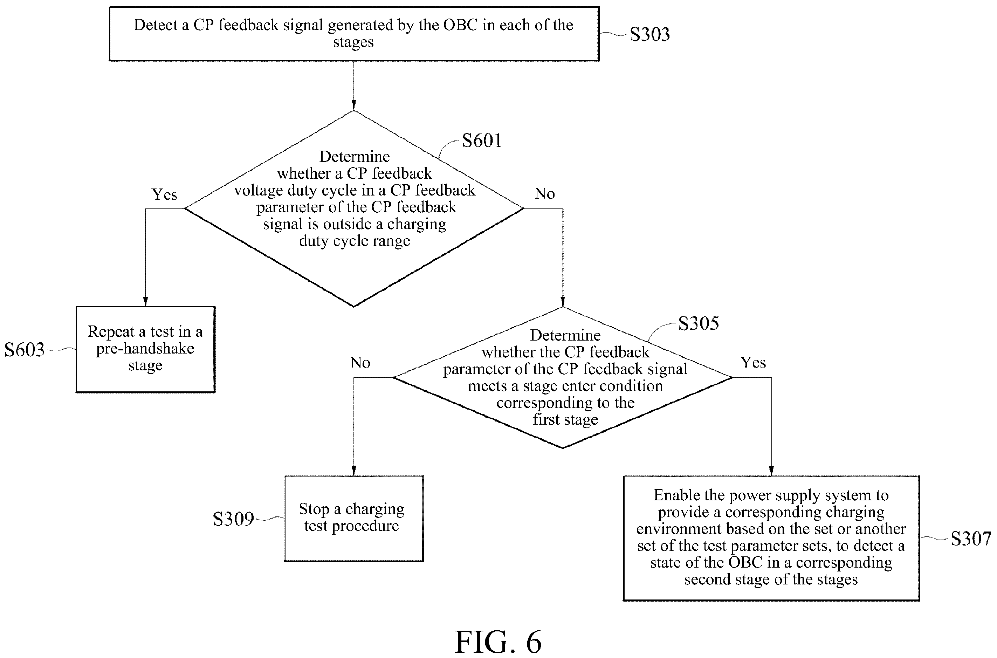

FIG. 6 is a flowchart of an on-board charging test method according to some embodiments of the present invention. In some embodiments, a memory 11 further has a charging duty cycle range stored therein. The charging duty cycle range is, for example, a range of 10% to 90%. In some embodiments, in a case that a charging stage E8 is used as a first stage, after an OBC 30 enters the charging stage E8 for a period of time (such as reaching a timing point T3), a processor 13 determines whether a CP feedback voltage duty cycle in the CP feedback parameter of a detected CP feedback signal CP_C in the charging stage E8 is outside a charging duty cycle range (step S601). If the CP feedback voltage duty cycle in the CP feedback parameter of the detected CP feedback signal CP_C in the charging stage E8 is not outside the charging duty cycle range (namely, the CP feedback voltage duty cycle is within the charging duty cycle range), the processor 13 performs step S305 and subsequent steps. If the CP feedback voltage duty cycle in the CP feedback parameter of the detected CP feedback signal CP_C in the charging stage E8 is outside the charging duty cycle range, it indicates that charging is not completed and requires restarting the connection handshake to recharge. In this case, the processor 13 repeats the test of the pre-handshake stage E4, which precedes the charging stage E8 (step S603) in the timing sequence and continues subsequent procedures. Specifically, the processor 13 enables the power supply system 20 to provide a corresponding charging environment based on the handshake test parameter set, to detect the state of the OBC 30 in the pre-handshake stage E4, and continues performing the test of subsequent stages. In some embodiments, step S501 precedes step S601. In this way, in step S501, when the CP feedback parameter of the CP feedback signal CP_C meets the error condition corresponding to the charging stage E8 as the first stage, the processor 13 performs step S601 and subsequent steps.

In some embodiments, the charging completion stage E9 corresponds to the charging completion test parameter set of the test parameter sets. Step S301 is described by using the charging completion stage E9 as the first stage below. Specifically, as shown in FIG. 4, the processor 13 enables the power supply system 20 to provide a corresponding charging environment based on the charging completion test parameter set, to detect the state of the OBC 30 in the charging completion stage E9. As shown in FIG. 4, in an exemplary example, when the test and the OBC 30 operate normally, the set CP transmission peak voltage of the CP transmission parameter of the CP transmission signal of the third node N3 of the charging completion test parameter set is +12 V, the set CP transmission valley voltage is -12 V, and the set CP transmission voltage duty cycle is 89.2%. In other words, the CP transmission signal of the third node N3 of the charging completion test parameter set is a 12 V PWM signal. The resistance parameter of the second node N2 of the charging completion test parameter set is the resistance value of the fifth resistor RC. The set power supply voltage of the power supply parameter of the charging completion test parameter set is 0 V and the set power supply current is 0 A.

After entering the charging completion stage E9, the OBC 30 is fully charged. The power supply system 20 continuously outputs a PWM signal (to be specific, a 12 V PWM signal) with a peak of +12 V (for example, the set CP transmission peak voltage of the charging completion test parameter set) and a valley of -12 V (for example, the set CP transmission valley voltage of the charging completion test parameter set) at the third node N3 as the CP transmission signal. In this case, the second switch S2 does not turn on a connection between the second resistor and the second ground terminal GND2 (namely, the second switch S2 is in an off state). Therefore, the CP transmission signal of the third node N3 forms the CP feedback signal CP_C through the third resistor R3. Specifically, due to the third resistor R3, the CP feedback peak voltage of the CP feedback parameter of the CP feedback signal CP_C is 9 V, the CP feedback valley voltage of the CP feedback parameter is 0 V, and the CP feedback voltage duty cycle of the CP feedback parameter is 89.2%. In other words, the CP feedback signal CP_C becomes a 9 V PWM signal.

In some embodiments, the charging completion stage E9 corresponds to the tenth determining condition of the error conditions. Therefore, when the charging completion stage E9 is used as the first stage, the processor 13 performs step S501 through the tenth determining condition of the error conditions. In some embodiments, since the tenth determining condition of the error conditions is the same as the fifth determining condition of the stage enter conditions (specifically, the set error peak voltage range, the set error valley voltage range, and the set error duty cycle range of the tenth determining condition are respectively the same as the set enter peak voltage range, the set enter valley voltage range, and the set enter duty cycle range of the fifth determining condition), details are not repeated. Since the determining manner in which the CP feedback parameter of the CP feedback signal CP_C meets the tenth determining condition is similar to the determining manner in which the CP feedback parameter of the CP feedback signal CP_C meets the fifth determining condition, details are not repeated. Since the determining manner in which the CP feedback parameter of the CP feedback signal CP_C meets the tenth determining condition is similar to the determining manner in which the CP feedback parameter of the CP feedback signal CP_C does not meet the fifth determining condition, details are not repeated.

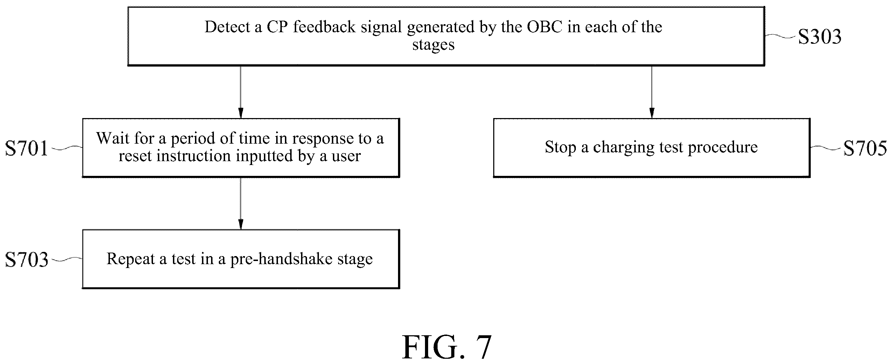

FIG. 7 is a flowchart of an on-board charging test method according to some embodiments of the present invention. Since the OBC 30 continuously self-discharges after being fully charged., one scenario is that when a user does not immediately remove a vehicle plug 23 of a power supply system 20 from an OBC 30 after the OBC 30 is fully charged, the power supply system 20 restarts the connection handshake to recharge. In some embodiments, to test this scenario, in a case that the charging completion stage E9 is used as the first stage, the processor 13 waits for a period of time in response to a reset instruction inputted by the user after the charging completion stage E9 is entered (step S701). After waiting for a period of time, the processor 13 repeats the test (step S703) of the pre-handshake stage E4, which precedes the charging completion stage E9 in the timing sequence and continues subsequent procedures, so as to restart the connection handshake and recharge. Specifically, in step S703, the processor 13 enables the power supply system 20 to provide a corresponding charging environment based on the handshake test parameter set, to detect the state of the OBC 30 in the pre-handshake stage E4, and continues performing the test of subsequent stages.

In some embodiments, in a case that the charging completion stage E9 is used as the first stage, while the OBC 30 is in the charging completion stage E9, the processor 13 responds to an a turn-off signal of a third switch S3 of a vehicle plug 23 (in other words, as shown in FIG. 2, the third switch S3 disconnects the connection between the fifth resistor RC and the first ground terminal GND1, namely, the third switch S3 is in an off state) and learns that the user removes the vehicle plug 23 of the power supply system 20 from the OBC 30. Therefore, the charging test procedure is stopped (step S705).

Based on the above, according to some embodiments, the present invention modularizes the charging test of the OBC through the test parameter sets and the stage enter conditions. In this way, the quantity of test items can be reduced under the charging protocol that conforms to the OBC, thereby improving the detecting efficiency.

## Claims

1. An on-board charging test system (10), comprising:
a memory (11), having at least one command, a plurality of test parameter sets, and a plurality of stage enter conditions stored therein, wherein the test parameter sets and the stage enter conditions respectively correspond to a plurality of stages (E1-E9) of an on-board charger (OBC) (30) in a charging process; and
a processor (13), coupled to the memory (11) and configured to access and execute the at least one command in the memory (11) to perform a charging test procedure, wherein the charging test procedure comprises:
enabling a power supply system (20) to provide a corresponding charging environment based on one of the plurality of test parameter sets, to detect a state of the OBC (30) in a corresponding first stage of the stages (E1-E9);
detecting a control pilot (CP) feedback signal generated by the OBC (30) in each of the stages (E1-E9); and
enabling the power supply system (20) to provide a corresponding charging environment based on the set or another set of the test parameter sets when a signal parameter of the CP feedback signal meets the stage enter condition corresponding to the first stage after the OBC (30) enters the first stage for a period of time, to detect a state of the OBC (30) in a corresponding second stage of the stages (E1-E9), wherein the second stage follows the first stage.

2. The on-board charging test system (10) according to claim 1, **characterized in that** after the OBC (30) enters the first stage for a period of time, the processor (13) stops the charging test procedure when the signal parameter of the CP feedback signal does not meet the stage enter condition corresponding to the first stage.

3. The on-board charging test system (10) according to claim 1 or 2, **characterized in that** the signal parameter of the CP feedback signal comprises a peak voltage, a valley voltage, and a voltage duty cycle, and each of the stage enter conditions comprises that the peak voltage is within a set enter peak voltage range, the valley voltage is within a set enter valley voltage range, and the voltage duty cycle is within a set enter duty cycle range.

4. The on-board charging test system (10) according to claim 1, **characterized in that** the power supply system (20) comprises a vehicle plug (23) for the OBC (30) to connect, the test parameter sets comprise a startup test parameter set, the stages (E1-E9) comprise a ready-to-startup stage (E1) and a startup stage (E2), the startup test parameter set corresponds to the startup stage (E2), the startup stage (E2) follows the ready-to-startup stage (E1), and the step of enabling the power supply system (20) to provide the corresponding charging environment based on one of the plurality of test parameter sets, to detect the state of the OBC (30) in the corresponding first stage of the stages (E1-E9) comprises: enabling the power supply system (20) to provide the corresponding charging environment based on the startup test parameter set in response to a turn-on signal of a switch (S3) of the vehicle plug (23) when the OBC (30) is in the ready-to-startup stage (E1), to detect a state of the OBC (30) in the startup stage (E2).

5. The on-board charging test system (10) according to claim 1, **characterized in that** the memory (11) has a plurality of error conditions stored therein, the error conditions correspond to the stages (E1-E9) of the OBC (30) in the charging process, and the charging test procedure further comprises: stopping, by the processor (13), the charging test procedure when the signal parameter of the CP feedback signal does not meet the error condition corresponding to the first stage within a period of time after the OBC (30) enters the first stage.

6. The on-board charging test system (10) according to claim 5, **characterized in that** the signal parameter of the CP feedback signal comprises a peak voltage, a valley voltage, and a voltage duty cycle, and each of the error conditions comprises that the peak voltage is within a set error peak voltage range, the valley voltage is within a set error valley voltage range, and the voltage duty cycle is within a set error duty cycle range.

7. The on-board charging test system (10) according to claim 1, **characterized in that** the memory (11) has a charging duty cycle range stored therein, the test parameter sets comprise a handshake test parameter set, the stages (E1-E9) comprise a pre-handshake stage (E4) and a charging stage (E8), the handshake test parameter set corresponds to the pre-handshake stage (E4), the pre-handshake stage (E4) precedes the charging stage (E8), and the charging test procedure further comprises: enabling the power supply system (20) to provide the corresponding charging environment based on the handshake test parameter set when a voltage duty cycle in the signal parameter of the CP feedback signal is outside the charging duty cycle range after the OBC (30) enters the charging stage (E8) for a period of time, to detect a state of the OBC (30) in the pre-handshake stage (E4).

8. The on-board charging test system (10) according to claim 1, **characterized in that** the test parameter sets comprise a handshake test parameter set, the stages (E1-E9) comprise a pre-handshake stage (E4) and a charging completion stage (E9), the handshake test parameter set corresponds to the pre-handshake stage (E4), the pre-handshake stage (E4) precedes the charging completion stage (E9), and the charging test procedure further comprises: enabling, in response to a reset instruction, the power supply system (20) to provide a corresponding charging environment based on the handshake test parameter set after the OBC (30) enters the charging completion stage (E9) for a period of time, to detect a state of the OBC (30) in the pre-handshake stage (E4).

9. The on-board charging test system (10) according to claim 1, **characterized in that** the power supply system (20) comprises a vehicle plug (23) for the OBC (30) to connect, the stages (E1-E9) comprise a charging completion stage (E9), and the charging test procedure further comprises: stopping the charging test procedure in response to a turn-off signal of a switch (S3) of the vehicle plug (23) when the OBC (30) is in a charging completion stage (E9).

10. An on-board charging test method, comprising:
enabling a power supply system (20) to provide a corresponding charging environment based on one of a plurality of test parameter sets, to detect a state of an on-board charger (OBC) (30) in a corresponding first stage of a plurality of stages (E1-E9) in a charging process, wherein the stages (E1-E9) correspond to the test parameter sets and a plurality of stage enter conditions;
detecting a control pilot (CP) feedback signal generated by the OBC (30) in each of the stages (E1-E9); and
enabling the power supply system (20) to provide a corresponding charging environment based on the set or another set of the test parameter sets when a signal parameter of the CP feedback signal meets the stage enter condition corresponding to the first stage after the OBC (30) enters the first stage for a period of time, to detect a state of the OBC (30) in a corresponding second stage of the stages (E1-E9), wherein the second stage follows the first stage.

11. The on-board charging test method according to claim 10, **characterized in that** further comprising: stopping the charging test when the signal parameter of the CP feedback signal does not meet the stage enter condition corresponding to the first stage after the OBC (30) enters the first stage for a period of time.

12. The on-board charging test method according to claim 10 or 11, **characterized in that** the signal parameter of the CP feedback signal comprises a peak voltage, a valley voltage, and a voltage duty cycle, and each of the stage enter conditions comprises that the peak voltage is within a set enter peak voltage range, the valley voltage is within a set enter valley voltage range, and the voltage duty cycle is within a set enter duty cycle range.

13. The on-board charging test method according to claim 10, **characterized in that** the power supply system (20) comprises a vehicle plug (23) for the OBC (30) to connect, the test parameter sets comprise a startup test parameter set, the stages (E1-E9) comprise a ready-to-startup stage (E1) and a startup stage (E2), the startup test parameter set corresponds to the startup stage (E2), the startup stage (E2) follows the ready-to-startup stage (E1), and the step of enabling the power supply system (20) to provide the corresponding charging environment based on one of the plurality of test parameter sets, to detect the state of the OBC (30) in the corresponding first stage of the stages (E1-E9) in the charging process comprises: enabling the power supply system (20) to provide the corresponding charging environment based on the startup test parameter set in response to a turn-on signal of a switch (S3) of the vehicle plug (23) when the OBC (30) is in the ready-to-startup stage (E1), to detect a state of the OBC (30) in the startup stage (E2).

14. The on-board charging test method according to claim 10, **characterized in that** the stages (E1-E9) correspond to a plurality of error conditions, and the on-board charging test method further comprises: stopping the charging test when the signal parameter of the CP feedback signal does not meet the error condition corresponding to the first stage within a period of time after the OBC (30) enters the first stage.

15. The on-board charging test method according to claim 14, **characterized in that** the signal parameter of the CP feedback signal comprises a peak voltage, a valley voltage, and a voltage duty cycle, and each of the error conditions comprises that the peak voltage is within a set error peak voltage range, the valley voltage is within a set error valley voltage range, and the voltage duty cycle is within a set error duty cycle range.

16. The on-board charging test method according to claim 10, **characterized in that** the plurality of test parameter sets comprise a handshake test parameter set, the stages (E1-E9) comprise a pre-handshake stage (E4) and a charging stage (E8), the handshake test parameter set corresponds to the pre-handshake stage (E4), the pre-handshake stage (E4) precedes the charging stage (E8), and the on-board charging test method further comprises: enabling the power supply system (20) to provide the corresponding charging environment based on the handshake test parameter set when a voltage duty cycle in the signal parameter of the CP feedback signal is outside a charging duty cycle range after the OBC (30) enters the charging stage (E8) for a period of time, to detect a state of the OBC (30) in the pre-handshake stage (E4).

17. The on-board charging test method according to claim 10, **characterized in that** the test parameter sets comprise a handshake test parameter set, the stages (E1-E9) comprise a pre-handshake stage (E4) and a charging completion stage (E9), the handshake test parameter set corresponds to the pre-handshake stage (E4), the pre-handshake stage (E4) precedes the charging completion stage (E9), and the on-board charging test method further comprises: enabling, in response to a reset instruction, the power supply system (20) to provide a corresponding charging environment based on the handshake test parameter set after the OBC (30) enters the charging completion stage (E9) for a period of times, to detect a state of the OBC in the pre-handshake stage (E4).

18. The on-board charging test method according to claim 10, **characterized in that** the power supply system (20) comprises a vehicle plug (23) for the OBC to connect, the stages (E1-E9) comprise a charging completion stage (E9), and the on-board charging test method further comprises: stopping the charging test in response to a turn-off signal of a switch (S3) of the vehicle plug (23) when the OBC (30) is in a charging completion stage (E9).
